# EUROPEAN PATENT APPLICATION

(11) **EP 4 759 607 A1**
(43) Date of publication of application: **17.06.2026**
(21) Application number: 24219539.4
(22) Date of filing: 12.12.2024
(51) Int. Cl.: B60L 3/00, B60L 58/21, B60L 58/22, B60L 58/26, H01M 10/48

(54) **ELECTRICAL ENERGY SYSTEM, VEHICLE AND METHOD**

(71) Applicant: SAMSUNG SDI CO., LTD., Yongin-si, Gyeonggi-do 17084 (KR)
(72) Inventor: Erhart, Michael, 8054 Seiersberg-Pirka (AT)
(74) Representative: Gulde & Partner

(57) **Abstract**

The electrical energy system (100) includes a high voltage system (10) with a plurality of battery cells (12) arranged in at least two strings (14a, 14b) of battery cells (12), the battery cells (12) of each string (14a, 14b) being connected in series, a low voltage system (16), at least one DC/DC converter (18a, 18b) for each of the strings (14a, 14b) of battery cells (12) connected in series to respective opposite ends of the strings (14a, 14b) of battery cells (12), the DC/DC converters (18a, 18b) being configured to down-convert a high voltage from the high voltage system (10) to a low voltage provided to the low voltage system (16), wherein the DC/DC converters (18a, 18b) are connected in parallel to the low voltage system (16), and a cell supervision system (20) for supervising voltages of individual battery cells (12) of the high voltage system (10) including a separate communication loop for each of the strings (14a, 14b) of battery cells (12) for independently supervising battery cell voltages within each of the strings (14a, 14b) of battery cells (12).

## Description

### Field of the Disclosure

The present disclosure relates to an electrical energy system and a method for a vehicle. The present disclosure further pertains to a vehicle including the electrical energy system.

### Technological Background

Recently, vehicles for transportation of goods and peoples have been developed that use electric power as a source for motion. Such an electric vehicle is an automobile that is propelled permanently or temporarily by an electric motor, using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to give power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. The shape of the casing may be, for example, cylindrical or rectangular.

A battery module is formed of a plurality of battery cells connected in series or in parallel. That is, the battery module is formed by interconnecting the electrode terminals of the plurality of battery cells depending on a required amount of power and in order to realize a high-power rechargeable battery.

Battery modules can be constructed in either a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage.

A battery pack is a set of any number of (for example identical) battery modules or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell, battery module, and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, or temperatures of individual battery cells), coolant flow (e.g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery cell, state of health (SOH; a variously-defined measurement of the remaining capacity of the battery cell as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be also distributed, with a BMS board is installed at each cell, with just a single communication cable between the battery cell and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated by over-current, over-voltage (during charging), over-temperature, under-temperature, over-pressure, and ground fault or leakage current detection. The BMS may prevent the battery from operating outside its safe operating parameter by including an internal switch (e.g., a relay or solid-state device) that opens if the battery is operated outside its safe operating parameters, requesting the devices to which the battery is connected to reduce or even terminate using the battery, and actively controlling the environment, such as through heaters, fans, air conditioning or liquid cooling.

Exothermic decomposition of cell components may lead to a so-called thermal runaway. Generally, thermal runaway describes a process that accelerates due to increased temperature, in turn releasing energy that further increases temperature. Thermal runaway occurs in situations when an increase in temperature changes the conditions in a way that causes a further increase in temperature, often leading to a destructive result. In rechargeable battery systems, thermal runaway is associated with strong exothermic reactions that are accelerated by temperature rise. In thermal runaway, the battery cell temperature rises incredibly fast and the energy stored is released very suddenly. In extreme cases, thermal runaway can cause battery cells to explode and start fire. In minor cases, it can cause battery cells to be damaged beyond repair.

When a battery cell is heated above a critical temperature (for example, above 150°C) the battery cell can transition into a thermal runaway. Generally, temperatures outside of the safe region on either the low or high side may lead to irreversible damage to the battery cell and therefore may possible trigger thermal runaway. Thermal runaway may also occur due to an internal or external short circuit of the battery cell or poor battery maintenance. For example, overcharging or rapid charging may lead to thermal runaway.

During thermal runaway, the failed battery cell may reach a temperature exceeding 700°C. Further, large quantities of hot gas are ejected from inside of the failed battery cell through the venting opening of the cell housing into the battery pack. The main components of the vented gas are H₂, CO₂, CO, electrolyte vapor and other hydrocarbons. The vented gas is therefore flammable and potentially toxic. The vented gas also causes a gas-pressure to increase inside the battery pack. In the worst case, the high temperatures lead to the process spreading to neighboring cells and fire in the battery pack. At this stage, the fire is hardly to extinguish.

The BMS is critical to the safe operation and optimal performance of rechargeable battery cells and helps minimize the possibility of thermal runaway. For example, if the BMS detects that the temperature is too hot, it can regulate the temperature by controlling cooling fans. Alternatively, if the battery cell cannot be cooled and safe conditions restored, the BMS may shut down necessary battery cells to protect the entire system.

Electrical vehicles may have a 12V lead acid battery for 12V power supply of different components connected to the 12V onboard power system of the vehicle. In general, the 12V lead acid battery may take the role of buffering the 12V onboard power system. The 12V lead acid battery may be charged over a DC/DC converter connected to a high voltage battery system. The DC/DC converter and the 12V lead acid battery may be used as redundant power supplies to the 12V onboard power system used for safety critical systems, e.g. in autonomous driving. In addition, the 12V lead acid battery may be used to supply electrical energy to the cooling pump for cooling the high voltage battery system. In case of a thermal runaway of a battery cell, turning on the cooling pump may be very helpful to stop or reduce excessive thermal propagation in the high voltage battery system. Accordingly, the activated cooling pump may help to cool down the failed battery cell, especially during a thermal runaway, and to protect adjacent cells by distributing the heat energy over the cooling liquid into the thermal mass of the entire battery system.

The high voltage supply fails in the case of a thermal runaway of the high voltage system. Consequently, the DC/DC converter connected to the high voltage system is unable to further supply the 12V onboard power system with 12V current. In this case, only the 12V lead acid battery is available as energy supply to the 12V onboard power system. However, as there is no starter for the combustion engine required in electrical vehicles, the 12V lead acid battery is nowadays getting smaller and smaller. Furthermore, since the cooling pump takes its electrical energy from the 12V onboard power system, the time for cooling the high voltage battery system by an active cooling pump is very limited when the high voltage system fails. This time decreases even further in case the 12V lead acid battery becomes old or is discharged due to prior long parking session, for example.

Therefore, there exists a demand for an electric energy system with increased safety and which is more resilient against failure.

### Summary of Invention

The invention is defined by the appended claims. The description that follows is subjected to this limitation. Any disclosure lying outside the scope of said claims is only intended for illustrative as well as comparative purposes.

According to one aspect of the present disclosure, an electrical energy system for a vehicle is provided. The electrical energy system includes a high voltage system including a plurality of battery cells arranged in at least two strings of battery cells, the battery cells of each string being connected in series, a low voltage system, at least one DC/DC converter for each of the strings of battery cells connected in series to respective opposite ends of the strings of battery cells, the DC/DC converters being configured to down-convert a high voltage from the high voltage system to a low voltage provided to the low voltage system, wherein the DC/DC converters are connected in parallel to the low voltage system, and a cell supervision system for supervising voltages of individual battery cells of the high voltage system including a separate communication loop for each of the strings of battery cells for independently supervising battery cell voltages within each of the strings of battery cells.

The cell supervision system may include a plurality of slave battery management systems (BMS) for each of the strings of battery cells for battery cell voltage sensing and balancing of the battery cell voltages within each of the strings of battery cells.

The electrical energy may further include a cooling pump for cooling the plurality of battery cells connected to the low voltage system, wherein the electrical energy system may be configured to operate the cooling pump in case of a thermal runaway of at least one of the battery cells by supplying electrical energy from at least one of the DC/DC converters related to the string of battery cells unaffected by the thermal runaway.

The high voltage system may be adapted to prevent, defer and/or reduce thermal propagation between the strings of battery cells in case of a thermal runaway occurring at one of the battery cells.

The low voltage system may not include a low voltage battery.

The strings of battery cells may be each connected in series.

Each of the DC/DC converters may be connected to the high voltage system via two power lines respectively, wherein the one of the power lines may include a diode for allowing conduction of electrical current towards the DC/DC converter.

The diode may be an active diode for actively controlling the electrical current conducting through the diode.

The electrical energy system may be configured to request the vehicle to switch into a limp home function to reduce the required power in the low voltage system in case of a failure in one of the DC/DC converters.

The electrical energy system may be configured to selectively shut off or connect one or both of the DC/DC converters to the low voltage system, wherein a time of operation of the DC/DC converters being shut off from the low voltage system may be limited.

According to another aspect of the present disclosure, an electric vehicle including the electrical energy system is provided.

Yet another aspect of the present disclosure refers to a method for a vehicle including the steps of a) providing the above-mentioned electrical energy system and b) independently supervising the battery cell voltages within each of the strings of battery cells.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates an electric circuit diagram of an electrical system according to an embodiment.
- Fig. 2: illustrates a section of the electric circuit diagram of the electrical system of Fig. 1 according to another embodiment.
- Fig. 3: illustrates a schematic flow chart of a method for a vehicle according to an embodiment.

### Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/-5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to one aspect of the present disclosure, an electrical energy system for a vehicle is provided. The electrical energy system includes a high voltage system including a plurality of battery cells arranged in at least two strings of battery cells, a low voltage system, at least one DC/DC converter for each of the strings of battery cells and a cell supervision system for supervising voltages of individual battery cells of the high voltage system.

The battery cells of each string of the high voltage system are connected in series. In other words, the battery cells of the plurality of battery cells of the high voltage system are partitioned or divided into separate functional units, each functional unit being connected to its own (at least one) DC/DC converter. That is, in case that one of the battery cells of the high voltage system causes failure, the corresponding functional unit including the failed battery cell may not supply electrical energy to its DC/DC converter anymore, while the remaining functional units still operate and supply their DC/DC converters with high voltage such that at least a partial energy supply from the high voltage system may be upheld.

Each of the DC/DC converters is connected in series to respective opposite ends of the (respective associated) string of battery cells. The DC/DC converters are configured to down-convert a high voltage from the high voltage system to a low voltage provided to the low voltage system. The DC/DC converters are connected in parallel to the low voltage system. In other words, in case one of the DC/DC converters is shut off, the respective other DC/DC converter(s) may still operate and supply the low voltage system with low voltage.

The cell supervision system includes a separate communication loop for each of the strings of battery cells for independently supervising battery cell voltages within each of the strings of battery cells. In other words, each string of battery cells is connected via a separate wiring to the cell supervision system. Accordingly, in case that one of the communication loops is subject to failure, e.g. due to high temperatures caused by a thermal runaway within one of the two strings of battery cells, the safe operation of at least other one of the two DC/DC converters may be ensured.

The DC/DC converters may be installed inside the high voltage system, e.g. inside the housing of the high voltage system. The DC/DC converters may be evenly referred to the plurality of battery cells. For example, in case of two DC/DC converters, each of the DC/DC converters may be supplied from of a different half of the high voltage system. This allows a full redundant operation of the DC/DC converters and provides a fail-safe voltage supply to the low voltage system, e.g. the 12V onboard power system, which may be used for safety critical systems, like autonomous driving, or a cooling system for cooling the high voltage system, such as a cooling pump.

According to one embodiment, the cell supervision system may include a plurality of slave battery management systems (BMS) for each of the strings of battery cells for battery cell voltage sensing and balancing of the battery cell voltages within each of the strings of battery cells. In other words, the slave battery management systems are configured to sense and balance battery cell voltages of the battery cells of the associated string of battery cells. Each of the slave BMS associated with one string of battery cells may be connected to the separate communication loop associated with the respective string of battery cells. That is, in case a slave BMS fails, only one of the DC/DC converters fails, namely the DC/DC converter associated with the string of battery cells including the affected slave BMS, while operation of the one or more other DC/DC converter(s) is still possible to supply low voltage to the low voltage system.

According to another embodiment, the electrical energy system may further include a cooling pump for cooling the plurality of battery cells connected to the low voltage system. The electrical energy system may be configured to operate the cooling pump in case of a thermal runaway of at least one of the battery cells by supplying electrical energy from at least one of the other DC/DC converters related to the string(s) of battery cells unaffected by the thermal runaway. In other words, due to the redundancy of the supply to the onboard power system, it is possible to operate the cooling pump via the onboard power system in the case of a thermal runaway of one battery cell of the high voltage system. That is, the string of battery cells unaffected by the thermal runaway still provides electrical energy to the DC/DC to supply the cooling pump. The cooling pump may be connected to a liquid coolant cycle and may be configured to displace the coolant present in the liquid coolant cycle to exchange (excessive) heat from the battery cell(s).

According to another embodiment, the high voltage system may be adapted to prevent, defer and/or reduce thermal propagation between the strings of battery cells in case of a thermal runaway occurring at one of the battery cells. In other words, the high voltage system may be designed to allow no significant thermal propagation between the strings of battery cells. Accordingly, it may be ensured that the respective other string of battery cells remains unaffected by thermal events of an adjacent string of battery cells such that supply of the onboard power system may be maintained, e.g. to ensure operation of the cooling pump. For example, each of the string of battery cells may be housed in a separate housing and/or includes a venting system to guide excessive heat via air ventilation in a direction different from adjacent strings of battery cells.

According to another embodiment, the low voltage system may not include a low voltage battery. More specifically, the low voltage provided in the low voltage system may not be provided by a low voltage battery. In other words, the low voltage system may be only supplied by the one or more DC/DC converters. Instead of using a 12V lead acid battery, which becomes less useful in electrical vehicles due to the lack of a need of a starter for a combustion engine, supply of the onboard power system (and e.g. the cooling pump) is ensured by using the at least two independent strings of battery cells of the high voltage system with two DC/DC converters.

According to another embodiment, the strings of battery cells may be each connected in series. The series connection of the strings of battery cells allows to generate a higher total voltage.

According to another embodiment, each of the DC/DC converters may be connected to the high voltage system via two power lines, respectively. One of the power lines may include a diode for allowing conduction of electrical current towards the DC/DC converter (and preventing conduction of electrical current form the DC/DC converter towards the high voltage system). In other words, in addition to the high voltage power supply of the DC/DC converter provided by a first power line, a second power line including the diode may be used. For example, if the wiring of the first power line fails, the DC/DC converter can still be supplied via the second power line including the diode. The first and second power lines may each include at least one wiring interconnecting negative potentials and at least one wiring interconnecting positive potentials. That is, both wirings of the second power line may include a diode, respectively. The diodes may be passive diodes. Passive diodes are inexpensive and simple.

According to another embodiment, the diode may be an active diode for actively controlling the electrical current conducting through the diode. Active diodes may be used to overcome high power dissipations in the diode. In other words, active rectification, also known as synchronous rectification, may be used. Active rectification is a technique for improving the efficiency of rectification, e.g. by replacing diodes with actively controlled switches, usually power MOSFETs or power bipolar junction transistors (BJT).

According to another embodiment, the electrical energy system may be configured to request the vehicle to switch into a limp home function to reduce the required power in the low voltage system in case of a failure in one of the DC/DC converters. This allow to reduce the power for the DC/DC converters. For example, if the required power in the low voltage system can be cut in half during the limp home function, the operating power of each DC/DC converter can also be cut in half. In other words, the DC/DC converters may be downsized such that the cost of the DC/DC converters can be reduced.

According to another embodiment, the electrical energy system may be configured to selectively shut off or connect one or both of the DC/DC converters to the low voltage system. A time of operation of the DC/DC converters being shut off from the low voltage system may be limited. When a DC/DC converter is shut off from the low voltage system, the strings of battery cells of the high voltage system are discharged unevenly. Due to the time limit, too much disbalance of the charge states between the strings of battery cells may be prevented. Accordingly, the service life of the electrical energy system may be preserved.

The invention further pertains to an electric vehicle including the above-mentioned electrical energy system. The features and advantages described in view of the above-mentioned electrical energy system may be analogously applied to the electric vehicle.

Further, the invention pertains to a method for a vehicle, e.g. the above-mentioned vehicle. The features and advantages described in view of the above-mentioned electrical energy system or the above-mentioned vehicle including the electrical energy system may be analogously applied to the method.

According to a first step of the method, the above-mentioned electrical energy system is provided.

According to a second step of the method, the battery cell voltages within each of the string of battery cells is supervised independently. In other words, the battery cell voltages of each individual battery of the strings of battery cells are supervised through the supervision cell system connected to the high voltage system via the separate communication loops.

### Specific Embodiments

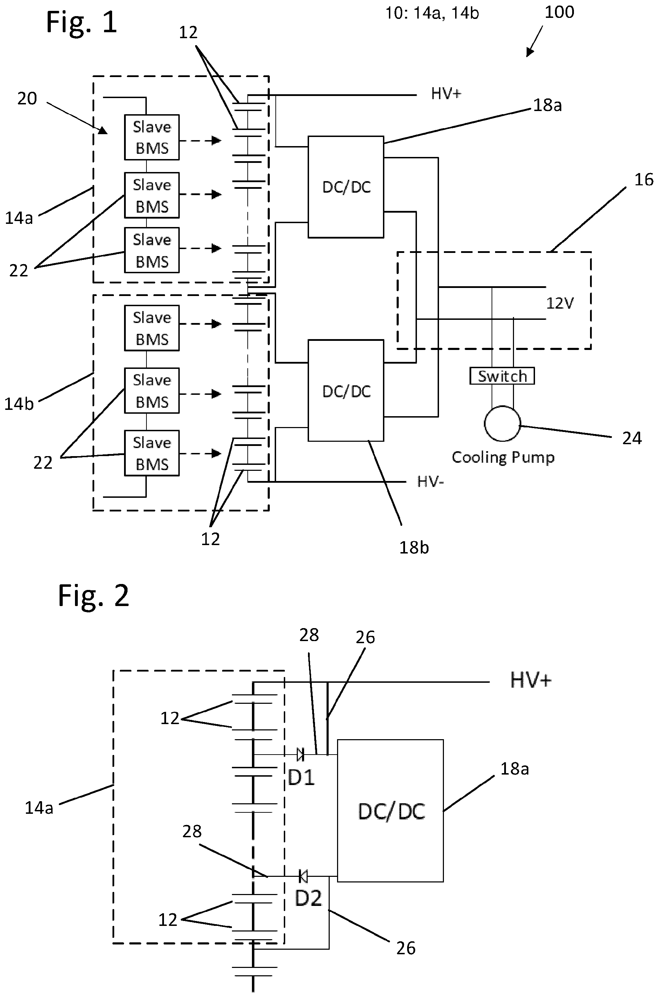

Fig. 1 depicts an electric circuit diagram of an electrical system 100 according to an embodiment.

The electrical system 100 includes a high voltage system 10 configured to provide a high voltage. The high voltage system 10 includes a plurality of battery cells 12 arranged in two strings 14a, 14b of battery cells 12. Although two strings 14a, 14b of battery cells are shown, the invention is not limited thereto. For example, the plurality of battery cells 12 may be arranged in any desired number of strings 14a, 14b of battery cells 12. The battery cells 12 of each string 14a, 14b of the high voltage system 10 are connected in series. In other words, the battery cells 12 of the high voltage system 10 are partitioned or divided into separate functional units. That is, in case that one of the battery cells 12 of the high voltage system 10 causes failure - e.g. a battery cell 12 of the first string 14a of battery cells 12 - only the functional unit corresponding the failed battery cell 12 of the high voltage system 10 may not work properly anymore to supply high voltage. The other functional unit(s) of the high voltage system 10 - e.g. the second string 14b of the high voltage system 10 - is/are still operating and supplying high voltage. Accordingly, a failure of a battery cell 12 does not cause a failure of the entire high voltage system 10. In contrast at least a part, e.g. the second half, of the high voltage system 10 provides high voltage.

The electrical energy system 100 further includes a low voltage system 16, e.g. a 12V onboard power system, and one DC/DC converter 18a, 18b for each of the strings 14a, 14b of battery cells 12. On the input side, the first DC/DC converter 18a is connected in series to the first string 14a of battery cells 12, more specifically to opposite ends of the first string 14a of battery cells 12. On the output side, the first DC/DC converter 18a is connected to the low voltage system 16. On the input side, the second DC/DC converter 18b is connected in series to the second string 14b of battery cells 12, more specifically to opposite ends of the second string 14b of battery cells 12. On the output side, the second DC/DC converter 18b is connected to the low voltage system 16.

The DC/DC converters 18a, 18b are configured to down-convert a high voltage from the high voltage system 10 to a low voltage, e.g. to 12 V, provided to the low voltage system 16, thereby supplying the low voltage system 16 with electrical energy provided by the high voltage system 10. For example, the high voltage system 10 and the DC/DC converters 18a, 18b may represent the only supply source of electrical energy of the low voltage system 16. That is, in some embodiments, the electrical energy system 100 may not include a (separate) low voltage battery, e.g. a 12V lead acid battery.

Furthermore, the DC/DC converters 18a, 18b are connected in parallel to the low voltage system 16. This configuration allows redundancy, e.g. in case that the first DC/DC converter 18a is shut off or subject to failure, the second DC/DC converter 18b still operates and supplies the low voltage system 16 with low voltage (and vice versa). For example, the DC/DC converters 18a, 18b may each be connected to at least two of the strings 14a, 14b of battery cells 12 via redundant wirings. In other words, the DC/DC converters 18a, 18b may be redundantly supplied by two cell stacks. For example, a string 14a, 14b of battery cells 12 may be connected to more than one DC/DC converter 18a, 18b via the redundant wirings. This allows a full redundant 12V power supply in case of a failure inside the electrical system 100. The redundant wirings may include a plurality of wirings interconnecting the DC/DC converters 18a, 18b individually to the at least two of the strings 14a, 14b of battery cells 12, i.e. at the point where two wirings come together, a second wire is used for redundancy.

As further shown in Fig. 1, the electrical energy system 100 includes a cell supervision system 20 for supervising voltages of individual battery cells 12 of the high voltage system 10. The cell supervision system 20 includes a separate communication loop for each of the strings 14a, 14b of battery cells 12 for independently supervising battery cell voltages within each of the strings 14a, 14b of battery cells 12. In other words, each string 14a, 14b of battery cells 12 is connected via a separate wiring to the cell supervision system 20. Accordingly, in case that one of the communication loops is subject to failure, e.g. due to high temperatures caused by a thermal runaway within one of the strings 14a, 14b of battery cells 12, the safe operation of at least the other one of the DC/DC converters 18a, 18b may be ensured.

More specifically, the cell supervision system 20 includes a plurality of slave battery management systems, BMS, 22 for each of the strings 14a, 14b of battery cells 12 for battery cell voltage sensing and balancing of the battery cell voltages within each of the strings 14a, 14b of battery cells 12. The slave BMSs 22 of one communication loop may communicate via one daisy chain bus. In other words, the cell supervision system 20 may include a daisy chain bus for each of the communication loops. The daisy chain buses of the separate communication loops may not be interconnected. Accordingly, even if the communication of one daisy chain bus is interrupted, the communication of the remaining daisy chain bus(es) is maintained. For example, the cell supervision system 20 may include three slave BMS 22 for the first string 14a of battery cells 12 and another three slave BMS 22 for the second string 14b of battery cells. As indicated by the dotted arrows in Fig. 1, each of the slave BMS 22 is separately connected to the respective battery cells 12 by a separate wiring. That is, the communication loops may include a separate wiring for each of the slave BMS 22. In other words, each of the slave BMS 22 associated with one string 14a, 14b of battery cells 12 may be connected to the separate communication loop associated with the respective string 14a, 14b of battery cells 12.

That is, in case a slave BMS 22 fails, (only) the DC/DC converter 18a, 18b associated with or affected by the failed slave BMS 22 is disconnected from the low voltage system 16. Alternatively, only the battery cell(s) 12 supervised by the failed slave BMS 22 may be shut down, i.e. disconnected from the string 14a, 14b associated with the failed slave BMS 22, e.g. via a switching means configured to disconnect one or each of the battery cells 12 supervised by one of the slave BMS 22 from the string 14a, 14b of battery cells 12 and to maintain the connection of the remaining string 14a, 14b of battery cells 12 through a connection line bypassing the disconnected battery cell(s) 12 (not shown in Fig. 1). Accordingly, the output of high voltage of the respective string 14a, 14b of battery cells 12 to the DC/DC converter 18a, 18b is reduced by that amount of the failed battery cell(s) 12. Nevertheless, operation of the one other DC/DC converter 18a, 18b not affected by the failed slave BMS 22 is independently possible such that the supply of low voltage to the low voltage system may be ensured even if a slave BMS 22 is subject to failure.

The electrical energy system 100 further includes a cooling system, e.g. a cooling pump 24, for cooling the plurality of battery cells 12 of the high voltage system 10. The cooling pump 24 is connected to a liquid coolant cycle and configured to displace the coolant present in the liquid coolant cycle to exchange (excessive) heat from the battery cell(s) 12. The cooling pump 24 is connected via a switch to the low voltage system 16. The switch may be selectively turned on or off to provide electrical power from the low voltage system 16 to the cooling pump 24. In other words, the cooling pump 24 may be activated or deactivated by controlling the switch.

The electrical energy system 100 is further configured to operate the cooling pump 24 in case of a thermal runaway of at least one of the battery cells 12 by maintaining the supply of electrical energy from the high voltage system 10 via at least one of the DC/DC converters 18a, 18b related to the string(s) 14a, 14b of battery cells 12 which is unaffected by the thermal runaway of the at least one battery cell 12. In other words, due to the redundancy of the supply to low voltage system 16, e.g. the onboard power system of the electric vehicle, the operation of the cooling pump 24 can be ensured even in the case of a thermal runaway of one battery cell 12 of the high voltage system 10.

Fig. 2 illustrates a section of the electric circuit diagram of the electrical system 100 of Fig. 1 according to another embodiment. For the sake of clarity and brevity, the section of the electric circuit diagram of the electrical system 100 shown in Fig. 2 illustrate further features with reference to the first string 14a of battery cells 12. However, the features may be analogously applied with reference to the second string 14b of the battery cells 12 or any other desired number of strings 14a, 14b of battery cells 12. The description of recurrent features will be omitted and merely differences to the embodiment as shown in Fig. 1 are described in the following.

In the embodiment as shown in Fig. 2, the DC/DC converter 18a is connected to the high voltage system 10 via two (power) transmission lines 26, 28. The first transmission line 26 is connected to the opposite ends of the first string 14a of battery cells 12. More specifically, the first transmission line 26 includes one wiring interconnecting negative potentials of one end of the first string 14a of battery cells 12 with the first DC/DC converter 18a and one wiring interconnecting positive potentials of the opposite end of the first string 14a of battery cells 12 with the first DC/DC converter 18a. For example, in the case that a thermal runaway occurring in one or more of the battery cells 12 of the first string 14a of battery cells 12, the wiring(s) of the first transmission line 26 may also be damaged, i.e. interrupted, due to the thermal runaway.

For this case, the electrical energy system 100 further includes a second (power) transmission line 28 connecting the first string 14a of battery cells 12 with the first DC/DC converter 18a. The second transmission line 28 is connected to interposed battery cells 12 of the first string 14a of battery cells 12. More specifically, the second transmission line 28 includes one wiring interconnecting negative potentials of interposed battery cells 12 of the first string 14a of battery cells 12 with the first DC/DC converter 18a and one wiring interconnecting positive potentials other interposed battery cells 12 of the first string 14a of battery cells 12 with the first DC/DC converter 18a. Due to the structurally different connecting points and that it is unlikely that a thermal runaway will cause damage to or interrupt every of the wirings of the first and second transmission lines 26, 28, the wired connection between the high voltage system 10 and the first DC/DC converter 18a may be uphold in a vast majority of cases of thermal runaway. Accordingly, the first the DC/DC converter 18a can be supplied with high voltage even during the event of a thermal runaway.

The second transmission lines 28 each include a diode D1, D2 for allowing conduction of electrical current towards the first DC/DC converter 18a and for preventing reverse conduction of electrical current, i.e. from the first DC/DC converter 18a towards the high voltage system 10. The diodes D1, D2 may be passive diodes. However, the diodes D1, D2 may also be active diodes for actively controlling the electrical current conducting through the diode D1, D2. Active diodes may be used to overcome high power dissipations in the diode D1, D2.

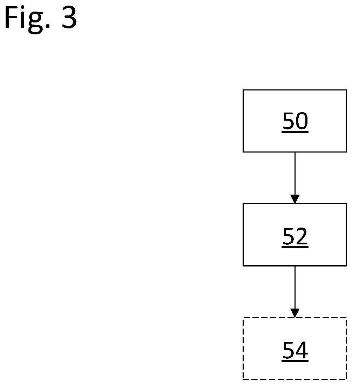

Fig. 3 illustrates a schematic flow chart of a method for a vehicle including the electric energy system 100 of Fig. 1 according to an embodiment.

According to a first step 50 the above-mentioned electrical energy system 100 is provided, i.e. an electrical energy system 100 including a high voltage system 10 including a plurality of battery cells 12 arranged in at least two strings 14a, 14b of battery cells 12, a low voltage system 16, at least one DC/DC converter 18a, 18b for each of the strings 14a, 14b of battery cells 12 and a cell supervision system 20 for supervising voltages of individual battery cells 12 of the high voltage system 10.

According to a second step 52 of the method, the battery cell voltages within each of the string 14a, 14b of battery cells 12 is supervised independently. In other words, the battery cell voltages of each individual battery 12 of the strings 14a, 14b of battery cells 12 are supervised through the supervision cell system 20 connected to the high voltage system 10 via the separate communication loops.

According to an optional third step 54 of the method, a cooling pump 24 connected to the low voltage system 12 is operated in the case of a thermal runaway of at least one of the battery cells 12 by supplying electrical energy from at least one of the DC/DC converters 18a, 18b related to the string 14a, 14b of battery cells 12 unaffected by the thermal runaway.

### Reference signs

- 10: high voltage system
- 12: plurality of battery cells
- 14a, 14b: strings of battery cells
- 16: low voltage system
- 18a, 18b: DC/DC converter
- 20: cell supervision system
- 22: slave battery management systems
- 24: cooling pump
- 26: first transmission lines
- 28: second transmission lines
- 50: first method step - providing an electrical energy system
- 52: second method step - independently supervising
- 54: optional third method step - operating cooling pump
- 100: electrical energy system

- D1, D2: diode

## Claims

1. An electrical energy system (100) for a vehicle, comprising:
a high voltage system (10) comprising a plurality of battery cells (12) arranged in at least two strings (14a, 14b) of battery cells (12), the battery cells (12) of each string (14a, 14b) being connected in series,
a low voltage system (16),
at least one DC/DC converter (18a, 18b) for each of the strings (14a, 14b) of battery cells (12) connected in series to respective opposite ends of the strings (14a, 14b) of battery cells (12), the DC/DC converters (18a, 18b) being configured to down-convert a high voltage from the high voltage system (10) to a low voltage provided to the low voltage system (16), wherein the DC/DC converters (18a, 18b) are connected in parallel to the low voltage system (16), and
a cell supervision system (20) for supervising voltages of individual battery cells (12) of the high voltage system (10) comprising a separate communication loop for each of the strings (14a, 14b) of battery cells (12) for independently supervising battery cell voltages within each of the strings (14a, 14b) of battery cells (12).

2. The electrical energy system (100) according to claim 1, wherein the cell supervision system (20) comprises a plurality of slave battery management systems, BMS, (22) for each of the strings (14a, 14b) of battery cells (12) for battery cell voltage sensing and balancing of the battery cell voltages within each of the strings (14a, 14b) of battery cells (12).

3. The electrical energy system (100) according to any one of the preceding claims, further comprising a cooling pump (24) for cooling the plurality of battery cells (12) connected to the low voltage system (16),
wherein the electrical energy system (100) is configured to operate the cooling pump (24) in case of a thermal runaway of at least one of the battery cells (12) by supplying electrical energy from at least one of the DC/DC converters (18a, 18b) related to the string (14a, 14b) of battery cells (12) unaffected by the thermal runaway.

4. The electrical energy system (100) according to any one of the preceding claims, wherein the high voltage system (10) is adapted to prevent, defer and/or reduce thermal propagation between the strings (14a, 14b) of battery cells (12) in case of a thermal runaway occurring at one of the battery cells (12).

5. The electrical energy system (100) according to any one of the preceding claims, wherein the low voltage system (16) does not comprise a low voltage battery.

6. The electrical energy system (100) according to any one of the preceding claims, wherein the strings (14a, 14b) of battery cells (12) are each connected in series.

7. The electrical energy system (100) according to any one of the preceding claims, wherein each of the DC/DC converters (18a, 18b) are connected to the high voltage system (10) via two power lines respectively, wherein one of the power lines comprises a diode (D1, D2) for allowing conduction of electrical current towards the DC/DC converter (18a, 18b).

8. The electrical energy system (100) according to claim 7, wherein the diode (D1, D2) is an active diode (D1, D2) for actively controlling the electrical current conducting through the diode (D1, D2).

9. The electrical energy system (100) according to any one of the preceding claims, wherein the electrical energy system (100) is configured to request the vehicle to switch into a limp home function to reduce the required power in the low voltage system (16) in case of a failure in one of the DC/DC converters (18a, 18b).

10. The electrical energy system (100) according to any one of the preceding claims, wherein the electrical energy system (100) is configured to selectively shut off or connect one or both of the DC/DC converters (18a, 18b) to the low voltage system (16),
wherein a time of operation of the DC/DC converters (18a, 18b) being shut off from the low voltage system (16) is limited.

11. An electric vehicle including the electrical energy system (100) according to any one of the preceding claims.

12. A method for a vehicle, wherein the method includes the steps of:
a) providing (50) an electrical energy system (100) as defined in any one of the claims 1 to 10; and
b) independently supervising (52) the battery cell voltages within each of the strings (14a, 14b) of battery cells (12).

## Amended claims

### Amended claims in accordance with Rule 137(2) EPC.

1. An electrical energy system (100) for a vehicle, comprising:
a high voltage system (10) comprising a plurality of battery cells (12) arranged in at least two strings (14a, 14b) of battery cells (12), the battery cells (12) of each string (14a, 14b) being connected in series,
a low voltage system (16),
at least one DC/DC converter (18a, 18b) for each of the strings (14a, 14b) of battery cells (12) connected in series to respective opposite ends of the strings (14a, 14b) of battery cells (12), the DC/DC converters (18a, 18b) being configured to downconvert a high voltage from the high voltage system (10) to a low voltage provided to the low voltage system (16), wherein the DC/DC converters (18a, 18b) are connected in parallel to the low voltage system (16), and
a cell supervision system (20) for supervising voltages of individual battery cells (12) of the high voltage system (10) comprising a separate communication loop for each of the strings (14a, 14b) of battery cells (12) configured to independently supervise battery cell voltages within each of the strings (14a, 14b) of battery cells (12),
**characterized in that**
each of the DC/DC converters (18a, 18b) are connected to the high voltage system (10) via two power lines (26, 28) respectively, wherein one (28) of the power lines (26, 28) comprises a diode (D1, D2) for allowing conduction of electrical current towards the DC/DC converter (18a, 18b).

2. The electrical energy system (100) according to claim 1, wherein the cell supervision system (20) comprises a plurality of slave battery management systems, BMS, (22) for each of the strings (14a, 14b) of battery cells (12) for battery cell voltage sensing and balancing of the battery cell voltages within each of the strings (14a, 14b) of battery cells (12).

3. The electrical energy system (100) according to any one of the preceding claims, further comprising a cooling pump (24) for cooling the plurality of battery cells (12) connected to the low voltage system (16),
wherein the electrical energy system (100) is configured to operate the cooling pump (24) in case of a thermal runaway of at least one of the battery cells (12) by supplying electrical energy from at least one of the DC/DC converters (18a, 18b) related to the string (14a, 14b) of battery cells (12) unaffected by the thermal runaway.

4. The electrical energy system (100) according to any one of the preceding claims, wherein each of the strings (14a, 14b) of battery cells (12) is housed in a separate housing and/or includes a venting system to guide excessive heat via air ventilation in a direction different from adjacent strings (14a, 14b) of battery cells (12).

5. The electrical energy system (100) according to any one of the preceding claims, wherein the low voltage system (16) does not comprise a low voltage battery.

6. The electrical energy system (100) according to any one of the preceding claims, wherein the strings (14a, 14b) of battery cells (12) are each connected in series.

7. The electrical energy system (100) according to any one of the preceding claims, wherein the diode (D1, D2) is an active diode (D1, D2) for actively controlling the electrical current conducting through the diode (D1, D2).

8. The electrical energy system (100) according to any one of the preceding claims, wherein the electrical energy system (100) is configured to request the vehicle to switch into a limp home function to reduce the required power in the low voltage system (16) in case of a failure in one of the DC/DC converters (18a, 18b).

9. The electrical energy system (100) according to any one of the preceding claims, wherein the electrical energy system (100) is configured to selectively shut off or connect one or both of the DC/DC converters (18a, 18b) to the low voltage system (16),
wherein a time of operation of the DC/DC converters (18a, 18b) being shut off from the low voltage system (16) is limited.

10. An electric vehicle including the electrical energy system (100) according to any one of the preceding claims.

11. A method for a vehicle, wherein the method includes the steps of:
a) providing (50) an electrical energy system (100) as defined in any one of the claims 1 to 9; and
b) independently supervising (52) the battery cell voltages within each of the strings (14a, 14b) of battery cells (12).
